# EUROPÄISCHE PATENTSCHRIFT

(11) **EP 1 207 619 B1**
(45) Veröffentlichungstag und Bekanntmachung des Hinweises auf die Patenterteilung: **20.09.2006**
(21) Anmeldenummer: 01126313.4
(22) Anmeldetag: 06.11.2001
(51) Int. Cl.: H03B 5/12

(54) **Oszillatorschaltkreis**
Oscillator circuit
Circuit d'oscillateur

(30) Priorität: 17.11.2000 DE 10056942
(43) Veröffentlichungstag der Anmeldung: 22.05.2002
(73) Patentinhaber: Infineon Technologies AG, 81669 München (DE)
(72) Erfinder: Traub, Johann, 89415 Lauingen (DE)
(74) Vertreter: Epping - Hermann - Fischer

(56) Entgegenhaltungen:
- EP-A- 0 660 504
- BORREMANS M ET AL: "PHASE NOISE UP-CONVERSION REDUCTION FOR INTEGRATED CMOS VCOS" ELECTRONICS LETTERS, IEE STEVENAGE, GB, Bd. 36, Nr. 10, 11. Mai 2000 (2000-05-11), Seiten 857-858, XP000963910 ISSN: 0013-5194
- ZANNOTH M ET AL: "INTEGRATION SPANNUNGSABSTIMMBARER OSZILLATOREN FUER MOBILFUNKANWENDUNGEN" ELEKTROTECHNIK UND INFORMATIONSTECHNIK, SPRINGER VERLAG, WIEN, AT, Bd. 115, Nr. 7/8, 1998, Seiten 353-359, XP000848360 ISSN: 0932-383X
- ZOHIOS J ET AL: "A fully integrated 1 GHz BiCMOS VCO" ELECTRONICS, CIRCUITS AND SYSTEMS, 1999. PROCEEDINGS OF ICECS '99. THE 6TH IEEE INTERNATIONAL CONFERENCE ON PAFOS, CYPRUS 5-8 SEPT. 1999, PISCATAWAY, NJ, USA,IEEE, US, 5. September 1999 (1999-09-05), Seiten 193-196, XP010361535 ISBN: 0-7803-5682-9
- MUER DE B ET AL: "A 2-GHZ LOW-PHASE-NOISE INTEGRATED LC-VCO SET WITH FLICKER-NOISE UPCONVERSION MINIMIZATION" IEEE JOURNAL OF SOLID-STATE CIRCUITS, IEEE INC. NEW YORK, US, Bd. 35, Nr. 7, Juli 2000 (2000-07), Seiten 1034-1038, XP001100956 ISSN: 0018-9200

## Beschreibung

Die vorliegende Erfindung betrifft einen Oszillatorschaltkreis, aufweisend einen Oszillatorkern mit zumindest einer Induktivität und mit einer daran angeschlossenen ersten Kapazität und einer zweiten Kapazität, deren Kapazitätswerte mittels einer Steuerspannung einstellbar sind und einen mit dem Oszillatorkern gekoppelten Entdämpfungsverstärker mit einem ersten Transistor und einem zweiten Transistor, welche miteinander in einer nichtgalvanischen Kopplung kreuzgekoppelt sind.

An vollintegrierte, spannungsgesteuerte Oszillatoren (VCO, Voltage Controlled Oscillator), die Ausgangsfrequenzen im Gigahertz-Bereich haben, werden bei Anwendung im Mobilfunkbereich zunehmend hohe Anforderungen bezüglich ihres Phasenrauschen gestellt.

Das LC-Oszillatoren zugrundeliegende Prinzip der Erzeugung einer Sinusschwingung ist durch eine Entdämpfung eines LC-Schwingkreises mit Hilfe eines Verstärkers gekennzeichnet, vergleiche beispielsweise Tietze, Schenk: Halbleiter-Schaltungstechnik, 10. Auflage 1993, Seiten 458ff. Als Verstärker in integrierten VCO-Schaltungen werden üblicherweise rückkgekoppelte Differenzverstärker eingesetzt, welche in CMOS- oder Bipolar-Schaltungstechnik aufgebaut sind. Die Rückkopplung kann dabei so interpretiert werden, daß hierdurch ein negativer Widerstand gebildet ist, der einen Verlustwiderstand im Resonanzkreis beziehungsweise Schwingkreis kompensiert und den Resonanzkreis somit entdämpft.

In der Druckschrift "A 1.24-GHz Monolithic CMOS VCO with Phase Noise of -137 dBc/Hz at a 3-Megahertz Offset", C.M. Hung et al, IEEE Microwave and Guided Wave Letters, Vol. 9, No. 3, March 1999 ist ein in CMOS-Schaltungstechnik aufgebauter VCO angegeben, welcher zwei in je einer galvanischen Verbindung kreuzgekoppelte Transistoren als Verstärker aufweist. Als Stromquelle für den Differenzverstärker ist ein als Stromquelle geschalteter CMOS-Transistor zwischen VCO-Kern und Bezugspotentialanschluß geschaltet.

Ein gattungsgemäßer VCO, bei dem die Transistoren des Differenzverstärkers in einer nichtgalvanischen Kopplung kreuzgekoppelt sind, ist in der Druckschrift "A Fully Integrated VCO at 2 GHz", M. Zannoth, B. Kolb, J. Fenk, R. Weigl, IEEE Journal of Solid-State Circuits, Vol. 33, No. 12, December 1998 angegeben. Dieser ist in bipolarer Schaltungstechnik aufgebaut.

Die beschriebenen VCO-Schaltungen haben jedoch den Nachteil, daß aufgrund der eingesetzten Stromquellen der dem Differenzverstärker zur Verfügung stehende Spannungsbereich und damit die Signalamplituden am Resonator begrenzt sind, so daß auch die erzielbaren Phasenrausch-Eigenschaften begrenzt sind.

In dem Aufsatz von Borremans et al.: "Phase Noise Up-Conversion Reduction for Integrated CMOS VCOs", Electronics Letters, 11th May 2000, Vol. 36, No. 10, XP 000963910, ist ein spannungsgesteuerter Oszillator gezeigt. Das Impedanzproblem bezüglich DC-Bias wird dort durch eine geringe Impedanz für niederfrequente Signale gelöst. Hierfür ist eine aktive Rückführung vorgesehen.

Der Aufsatz "A Fully Integrated 1 GHz BiCMOS VCO", J. Zohios et al., Circuits and Systems, 1999, the 6^{th} IEEE International Conference, Cyprus 5-8 Sept. 1999, IEEE, US, 5. September 1999, Seiten 193-196, XP 010361535, betrifft einen Oszillator, bei dem ein geringes Phasenrauschen durch hohe Ausgangsamplitude und mit Cu-Induktivitäten erzielt wird. Die Transistoren eines Stromspiegels werden mit einem konstanten BIAS-Strom gespeist.

Aufgabe der vorliegenden Erfindung ist es, einen gattungsbildenden Oszillatorschaltkreis derart weiterzubilden, daß der Aussteuerbereich vergrößert und das Phasenrauschen verringert ist.

Erfindungsgemäß wird die Aufgabe bei einem gattungsgemäßen Oszillatorschaltkreis mit den Merkmalen des Anspruchs 1 gelöst, bei dem je ein Lastanschluß je eines Transistors unmittelbar mit einem Bezugspotentialanschluß verbunden ist.

Der unmittelbar an Bezugspotential angeschlossene Lastanschluß der Transistoren ist dabei bevorzugt der Source-Anschluß eines Feldeffekt-Transistors oder der Emitteranschluß eines Bipolar-Transistors.

Dem Oszillatorschaltkreis liegt dabei das Prinzip zugrunde, die Transistoren des Entdämpfungsverstärkers nicht an eine Stromquelle anzuschließen, welche einen konstanten Strom liefert, und folglich die kreuzgekoppelten Transistoren als Differenzverstärker zu betreiben, sondern die Transistoren unmittelbar an einen Bezugspotentialanschluß anzuschließen, so daß über den Transistoren gleichspannungsmäßig die volle Versorgungsspannung abfallen kann und somit ein maximaler Spannungshub möglich ist und die Transistoren als Schalter oder Stromschalter betrieben sind. In der Kreuzkopplung der Transistoren ist hierfür eine galvanische Trennung zwischen Steuer- und Lastanschlüssen der Transistoren in der Kreuzkopplung erforderlich. Diese kann durch nichtgalvanische Kopplungen, wie transformatorische Kopplung oder kapazitive Kopplung erzielt sein.

Weiterhin ist zum Betrieb des Oszillatorschaltkreises eine Regelschaltung vorgesehen, welche die Vorspannung der Transistoren sowie den Betriebsstrom der Schaltung regelt.

Insgesamt zeigt der Oszillatorschaltkreis eine hohe Stabilität, eine gute Integrierbarkeit, eine Eignung für den Betrieb mit hohen Frequenzen im Gigahertzbereich und ein geringes Phasenrauschen aufgrund der höheren Aussteuerbarkeit. Aufgrund des höheren Spannungshubes an den Eingängen des Entdämpfungsverstärkers können Transistoren kleinerer Bauart eingesetzt sein, welche mit höherer Stromdichte betreibbar sind. Der Einsatz kleinerer Transistoren, welche kleinere parasitäre Kapazitäten haben, erlaubt den Einsatz größerer Kapazitäten mit abstimmbarem Kapazitätswert im Oszillatorkern, wodurch der Abstimmbereich des Oszillatorschaltkreises größer ist.

Zudem haben Transistoren mit höherer Stromdichte ein besseres Hochfrequenzverhalten, insbesondere eine höhere Transitfrequenz.

Zur weiteren Vergrößerung der Signalpegel sowie einer größeren Störfestigkeit kann der Oszillatorschaltkreis in differentieller Schaltungstechnik aufgebaut sein. Der Oszillatorschaltkreis ist in CMOS-Schaltungstechnik realisierbar.

In einer vorteilhaften Ausführungsform der vorliegenden Erfindung ist zur nichtgalvanischen Kopplung von erstem und zweitem Transistor über Kreuz ein erster Transformator vorgesehen, der einen Lastanschluß des ersten Transistors mit einem Steueranschluß des zweiten Transistors induktiv koppelt und es ist ein zweiter Transformator vorgesehen, der einen Lastanschluß des zweiten Transistors mit einem Steueranschluß des ersten Transistors induktiv koppelt. Die Induktivitäten bildenden Wicklungen der Transformatoren können zugleich Induktivitäten im Oszillatorkern des LC-Oszillators sein. Anstelle der Verwendung zweier Transformatoren kann ein Transformator, dessen Wicklungen jeweils eine Mittenanzapfung haben, verwendet sein.

In einer vorteilhaften Ausführungsform der Erfindung haben erster und zweiter Transformator jeweils ein von 1 verschiedenes Übersetzungsverhältnis. Das Übersetzungsverhältnis eines Transformators oder induktiven Übertragers ist dabei als Verhältnis der Windungszahlen von Primär- und Sekundärwicklung definiert. Mit einer transformatorischen Kopplung ist es damit möglich, die Steuerspannungen der Transistoren gegenüber den Spannungen am mit dem Steueranschluß gekoppelten Lastanschluß zu erhöhen, wodurch die Rauscheigenschaften des Oszillatorschaltkreises weiter verbessert sind.

In einer bevorzugten Ausführungsform ist zur nichtgalvanischen Kopplung von erstem und zweitem Transistor über Kreuz je ein Koppelkondensator zwischen Steuereingang des ersten und einem Lastanschluß des zweiten Transistors sowie zwischen Steuereingang des zweiten und einem Lastanschluß des ersten Transistors geschaltet. Die Koppelkondensatoren der kapazitiven Kopplung sind mit geringem Flächenbedarf auf einfache Weise integrierbar. Die kapazitive Kopplung kann zusätzlich Koppelwiderstände aufweisen zur Bildung einer Bias-Kopplung zwischen Lastanschlüssen der Transistoren und einer Bias-Regelschaltung.

In einer weiteren, vorteilhaften Ausführungsform ist eine Regelungsschaltung für eine Vorspannung der Transistoren vorgesehen, mit je einem Bias-Transistor, der jeweils steuerseitig an den Steuereingang des ersten beziehungsweise zweiten Transistors angeschlossen und lastseitig mit dem Oszillatorkern gekoppelt sowie an eine Referenzstromquelle angeschlossen ist. Die Vorspannungsregelung der Transistoren hält zugleich den Betriebsstrom der Oszillatorschaltung auf einem vorgegebenen Referenzwert. Hierdurch ergibt sich eine Unabhängigkeit der Oszillatorschaltung von Schwankungen der Versorgungsspannung und anderen streuenden Parametern.

In einer weiteren, bevorzugten Ausführungsform ist eine Regelungsschaltung für eine Vorspannung der Transistoren vorgesehen, welche einen als Diode geschalteten Bias-Transistor umfaßt, der einerseits mit dem Bezugspotentialanschluß verbunden und andererseits mit einer Referenzstromquelle verbunden und mit dem Oszillatorkern gekoppelt ist. Neben der Einsparung eines Bias-Transistors ist diese Ausbildung einer Regelungsschaltung gegenüber der oben genannten zur Realisierung eines rauschärmeren Oszillators geeignet.

In einer weiteren, bevorzugten Ausführungsform der Erfindung sind Ausgangstransistoren vorgesehen, deren Steuereingänge jeweils mit denen des ersten beziehungsweise zweiten Transistors verbunden sind, und die Lastanschlüsse haben, an denen ein als Differenzsignal vorliegendes Ausgangssignal der Oszillatorschaltung ableitbar ist. Der Strom des Ausgangssignals ist somit proportional zu dem Strom im Oszillatorkern, womit gute Gleichlaufeigenschaften verbunden sind. An die Ausgangstransistoren ist zur weiteren Signalverarbeitung beispielsweise eine Kaskodeschaltung anschließbar.

In einer weiteren, bevorzugten Ausführungsform umfassen erste und zweite Kapazität des Oszillatorkerns jeweils einen Kondensator mit daran angeschlossener Kapazitätsdiode. Mittels der der Oszillatorschaltung zuführbaren Steuerspannung können entweder die Kapazitätswerte der Kondensatoren oder die Kapazitätswerte der Kapazitätsdioden oder beide Kapazitätswerte einstellbar sein.

In einer weiteren, bevorzugten Ausführungsform der vorliegenden Erfindung sind die Kapazitätsdioden anodenseitig miteinander direkt verbunden. Hierdurch ist die Integrierbarkeit der Schaltung weiter verbessert.

In einer weiteren, bevorzugten Ausführungsform der Erfindung sind die Transistoren der Oszillatorschaltung CMOS-Transistoren.

Weitere Einzelheiten der Erfindung sind in den Unteransprüchen angegeben.

Die Erfindung wird nachfolgend an mehreren Ausführungsbeispielen anhand der Zeichnungen näher erläutert.

Es zeigen:
- Figur 1: ein Prinzipschaltbild eines Ausführungsbeispiels eines Oszillatorschaltkreises mit induktiver Kopplung,
- Figur 2: ein Prinzipschaltbild eines Ausführungsbeispiels eines Oszillatorschaltkreises mit kapazitiver Kopplung,
- Figur 3: eine Weiterbildung des Ausführungsbeispiels von Figur 1 mit lediglich einem Bias-Transistor und
- Figur 4: eine Weiterbildung des Ausführungsbeispiels von Figur 1 mit zusätzlichen Ausgangstransistoren.

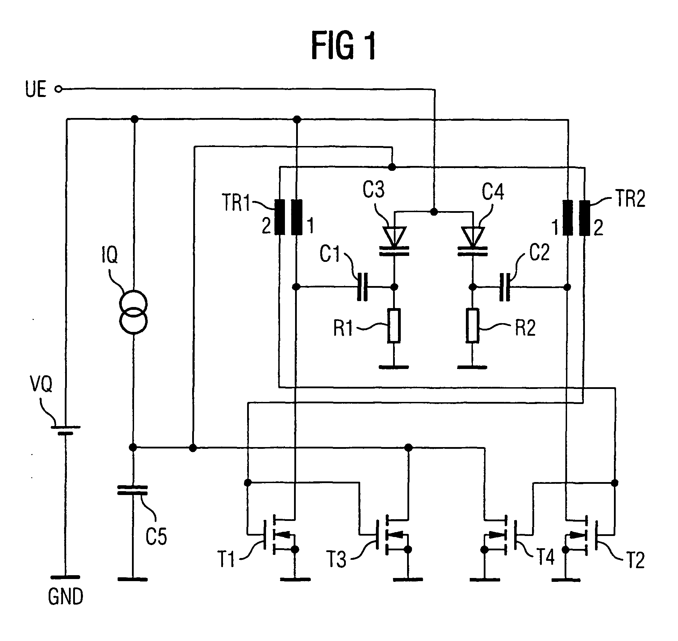

Figur 1 zeigt einen Oszillatorschaltkreis mit einem Oszillatorkern mit einer ersten Kapazität, welche einen Kondensator C1 und eine Kapazitätsdiode C3 umfaßt und mit einer zweiten Kapazität, welche einen Kondensator C2 und eine Kapazitätsdiode C4 umfaßt. Erste und zweite Kapazität bilden mit einem induktiven Anteil je eines Transformators TR1, TR2 einen LC-Schwingkreis. Die Transistoren T1, T2 eines Entdämpfungsverstärkers entdämpfen den Oszillatorkern. Zur Energieversorgung von Oszillatorkern und Entdämpfungsverstärker ist eine Spannungsquelle VQ vorgesehen. Die Einstellung der Vorspannung der Transistoren T1, T2 sowie die Regelung des Betriebsstroms der Schaltung erfolgt mit einer Regelungsschaltung, welche Bias-Transistoren T3, T4, eine Referenzstromquelle IQ sowie eine Kapazität C5 zur Stabilisierung des Arbeitspunktes umfaßt.

Dem Oszillatorkern, genauer den Kapazitätsdioden C3, C4, ist zur Frequenz-Abstimmung des Oszillatorkerns eine Steuerspannung UE zuführbar, welche anodenseitig an den Kapazitätsdioden C3, C4 anlegbar ist. An die Kathodenanschlüsse der Kapazitätsdioden C3, C4 ist je ein Kondensator C1, C2 sowie gegen einen Bezugspotentialanschluß GND je ein Widerstand R1, R2 angeschlossen. Ein weiterer Anschluß der Kondensatoren C1, C2 ist jeweils mit einem Transformator TR1, TR2 an einem Anschluß einer ersten Wicklung angeschlossen. Der andere Anschluß dieser ersten Wicklungen von erstem und zweitem Transformator ist zur Spannungsversorgung der Schaltung an eine Spannungsquelle VQ angeschlossen, die andererseits an den Bezugspotentialanschluß GND angeschlossen ist. Weiterhin ist an die erste Wicklung von erstem und zweitem Transformator TR1, TR2 je ein Lastanschluß des ersten beziehungsweise zweiten Transistors T1, T2 angeschlossen. Ein weiterer Lastanschluß der Transistoren T1, T2 ist jeweils mit dem Bezugspotentialanschluß GND unmittelbar und direkt verbunden. Zur Realisierung einer induktiven Kreuzkopplung ist der Steuereingang des ersten Transistors T1 mit einem Anschluß der zweiten Wicklung des zweiten Transformators TR2 und der Steuereingang des zweiten Transistors T2 mit einem Anschluß der zweiten Wicklung des ersten Transformators TR1 verbunden. Je ein weiterer Anschluß der zweiten Wicklungen von erstem und zweitem Transformator TR1, TR2 sind miteinander verbunden und an die Regelschaltung, genauer an einen Anschluß einer Kapazität C5 sowie einen Anschluß einer Referenzstromquelle IQ angeschlossen. Je ein weiterer Anschluß von fünfter Kapazität C5 und Referenzstromquelle IQ ist mit dem Bezugspotentialanschluß GND beziehungsweise mit einem Anschluß der ersten Wicklungen der beiden Transformatoren TR1, TR2 verbunden. Parallel zur Kapazität C5 sind gesteuerte Strecken von Bias-Transistoren T3, T4 geschaltet. Der Bias-Transistor T3 ist mit seinem Steuereingang an den Steuereingang des ersten Transistors T1, der Steuereingang des Bias-Transistors T4 ist mit dem Steuereingang des zweiten Transistors T2 unmittelbar verbunden.

Die beschriebene Oszillatorschaltung ist in CMOS-Schaltungstechnik aufgebaut. Der mit einem konventionell aufgebautem CMOS-Differenzverstärker praktisch realisierbare differentielle Spannungshub beträgt ca. 3,5 Volt Spitze-Spitze. Bei vorliegendem Oszillatorschaltkreis hingegen ist der differentielle Spannungshub am Resonator gleich der 4-fachen Differenz von Versorgungsspannung und Restspannung am Transistor, welche mit 700 mV angenommen wird. Bei einer Versorgungsspannung von 2,7 V kann folglich ein praktisch realisierbarer differentieller Spannungshub von 8 V Spitze-Spitze erreicht werden. Der Faktor 4 setzt sich dabei zum einen aus einem durch die differentiell ausgebildete Schaltungstechnik verursachten Faktor 2 und zum anderen durch einen weiteren Faktor 2 zusammen, welcher durch die induktive Beschaltung der Transistoren T1, T2 begründet ist.

Ein derart großer Signalhub ermöglicht ein sehr geringes Phasenrauschen des beschriebenen VCO.

Die mit Referenzstromquelle IQ, den Arbeitspunkt stabilisierender Kapazität C5 sowie den Bias-Transistoren T3, T4 gebildete Regelschaltung dient zum einen der Einstellung einer Vorspannung für die Transistoren und hält zum anderen den Betriebsstrom des Oszillatorschaltkreises auf einem vorgebbaren Referenzwert. Somit sind sowohl Betriebsstrom der Schaltung als auch die Signalamplituden des Oszillators nur sehr gering von Versorgungsspannungsschwankungen und anderen streuenden Parametern abhängig.

Die beschriebene Schaltungsanordnung eines spannungsgesteuerten Oszillators ist besonders gut in integrierter Schaltungstechnik realisierbar. Neben guter Stabilität der Regelungsschaltung zeigt der gesamte Oszillatorschaltkreis eine hohe Stabilität gegenüber Temperaturschwankungen.

Der beschriebene, hohe erzielbare Spannungshub am Eingang der Transistoren T1, T2, welcher durch geeignete Wahl von Übersetzungsverhältnissen der Transformatoren TR1, TR2 weiter vergrößert sein kann, ermöglicht den Einsatz verhältnismäßig kleiner Transistorstrukturen bei den Transistoren T1, T2, welche mit hoher Stromdichte betreibbar sind. Kleine Transistoren haben kleine parasitäre Kapazitäten, so daß der spannungsgesteuerte Oszillator einen größeren Abstimmbereich aufweist. Schließlich haben Transistoren, welche mit höherer Stromdichte betrieben werden, üblicherweise ein besseres Hochfrequenzverhalten und insbesondere eine höhere Transitfrequenz. Insgesamt ist somit das Hochfrequenzverhalten des VCO verbessert.

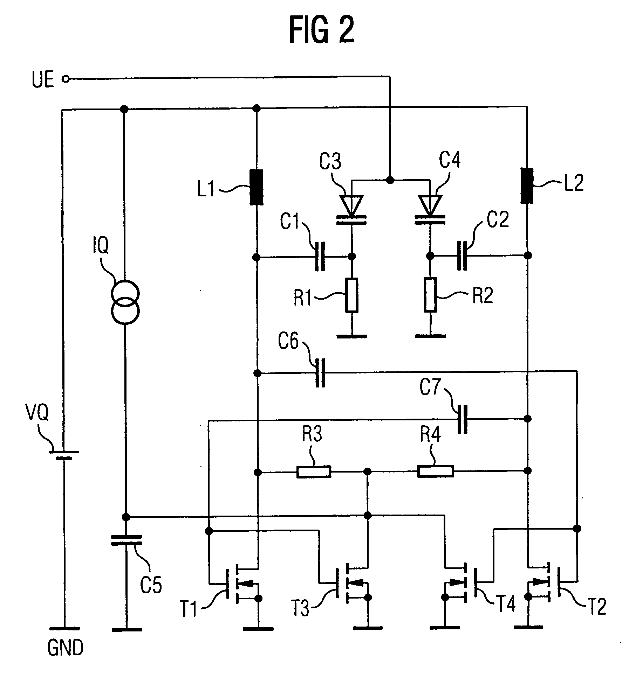

Figur 2 zeigt ein weiteres Ausführungsbeispiel eines Oszillatorschaltkreises anhand eines Blockschaltbildes, bei dem die mit Transformatoren realisierte Kreuzkopplung der Transistoren T1, T2 ersetzt ist durch eine kapazitive Kopplung mit Koppelkapazitäten C6, C7. Weiterhin sind zur Bereitstellung der Resonator-Induktivitäten Spulen L1, L2 anstelle der Transformatoren TR1, TR2 eingesetzt. Eine DC-Kopplung zwischen Oszillatorkern und Bias-Regelung ist mit Widerständen R3, R4 realisiert.

Im einzelnen ist eine erste Induktivität L1 einerseits an den ersten Kondensator C1 und andererseits an eine Spannungsquelle VQ angeschlossen, während eine zweite Induktivität L2 einerseits an einen zweiten Kondensator C2 und andererseits ebenfalls an die Versorgungsspannungsquelle VQ angeschlossen ist. Der Verbindungsknoten zwischen erster Induktivität L1 und erstem Kondensator C1 ist an einem Lastanschluß des ersten Transistors T1 angeschlossen, entsprechend ist der Verbindungsanschluß von zweiter Induktivität L2 und zweitem Kondensator C2 an einen Lastanschluß des zweiten Transistors T2 angeschlossen. Der Steuereingang des ersten Transistors T1 ist über einen Koppelkondensator C7 mit einem Lastanschluß des zweiten Transistors verbunden, mit einem Koppelkondensator C6 ist der Steuereingang des zweiten Transistors T2 in einer Kreuzkopplung mit einem Lastanschluß des ersten Transistors T1 verbunden. Zur Ankopplung der Regelungsschaltung an den Oszillatorkern sind zwei Widerstände R3, R4 gegenüber Figur 1 hinzugefügt, die einerseits miteinander und mit je einem Lastanschluß von Bias-Transistor T3 und T4 und die andererseits an je einen Lastanschluß von erstem beziehungsweise zweitem Transistor T1, T2 angeschlossen sind.

Die übrige Verschaltung von Oszillatorkern, erstem und zweitem Transistor T1, T2 sowie der Regelungsschaltung ist gegenüber dem Blockschaltbild von Figur 1 unverändert.

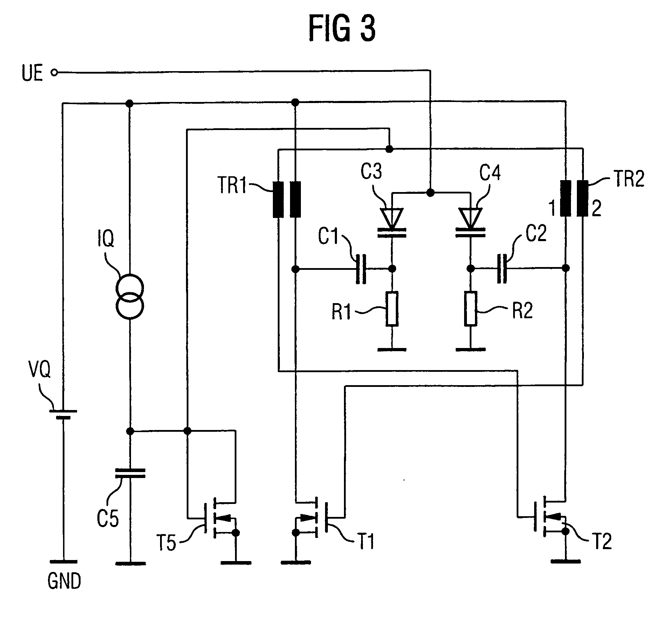

Figur 3 zeigt ein weiteres Ausführungsbeispiel einer Oszillatorschaltung, welche gegenüber der Schaltung von Figur 1 dahingehend verändert ist, daß die beiden Bias-Transistoren T3, T4 entfallen und mit lediglich einem als Diode geschalteten Bias-Transistor T5 ersetzt sind. Der Bias-Transistor T5 ist mit seinem Steuereingang an einen seiner Lastanschlüsse angeschlossen. Es besteht keine direkte Verbindung mehr zwischen Steuereingang des Bias-Transistors T5 und den Steuereingängen von erstem und zweitem Transistor T1, T2. Der als Diode verschaltete Transistor T5 ist parallel zur den Arbeitspunkt stabilisierenden Kapazität C5 gegen Masse geschaltet.

Gegenüber der Ausführungsform des Oszillatorschaltkreises mit zwei Bias-Transistoren gemäß Figur 1 hat die Ausführung mit lediglich einem Bias-Transistor gemäß Figur 3 den Vorteil, daß neben einer Ersparnis von Chipfläche insgesamt das Rauschen des Oszillatorschaltkreises reduziert ist.

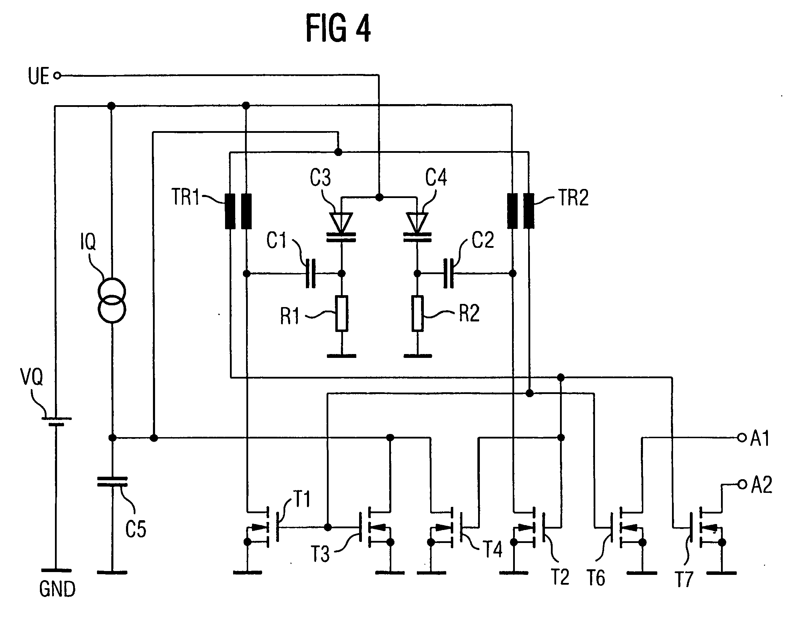

Ein weiteres Ausführungsbeispiel eines Oszillatorschaltkreises ist in Figur 4 dargestellt. Dieser Oszillatorschaltkreis ist gegenüber dem in Figur 1 gezeigten dadurch weitergebildet, daß zwei zusätzliche Ausgangstransistoren T6, T7 vorgesehen sind. Steuerseitig ist ein Ausgangstransistor T6 mit dem Steuereingang des ersten Transistors T1 und ein Steuereingang eines weiteren Ausgangstransistors T7 mit dem Steuereingang des zweiten Transistors T2 verbunden. Die Source-Anschlüsse der NMOS-Ausgangstransistoren T6, T7 sind ebenso wie die Source-Anschlüsse der NMOS-Transistoren T1 bis T4 unmittelbar an einen Bezugspotentialanschluß GND angeschlossen. Die Drain-Anschlüsse der Ausgangstransistoren T6, T7 bilden ein Ausgangsklemmenpaar mit zwei Ausgängen A1, A2, zwischen denen ein als Differenzsignal bereitgestelltes Ausgangssignal ableitbar ist. Die beschriebene Ausgangsbeschaltung ermöglicht, da die Ströme an den Ausgangsklemmen A1, A2 gleich denen im Oszillatorkern sind, gute Gleichlaufeigenschaften sowie ein gutes Matching.

Anstelle des beschriebenen Oszillatorkerns mit den Kapazitäten C1, C2, den Widerständen R1, R2 und den Kapazitätsdioden C3, C4 können auch andere Ausführungen eines abstimmbaren Oszillatorkerns vorgesehen sein. Beispielsweise können die Widerstände R1, R2 sowie die Koppelkapazitäten C1, C2 entfallen und die verbleibenden Kapazitätsdioden können anodenseitig oder kathodenseitig unmittelbar miteinander in einem Knoten verbunden sein, in dem die Abstimm-Spannung oder Steuerspannung UE zuführbar ist.

Anstelle der in den Figuren gezeigten NMOS-Transistoren, das heißt n-Kanal-Transistoren, können auch PMOS- oder p-Kanal-Transistoren verwendet sein, wobei NMOS-Transistoren in vorliegendem Oszillatorschaltkreis bessere Hochfrequenzeigenschaften ermöglichen.

## Patentansprüche

1. Oszillatorschaltkreis, aufweisend
einen Oszillatorkern mit zumindest einer Induktivität (TR1) und mit einer daran angeschlossenen ersten Kapazität (C1, C3) und einer zweiten Kapazität (C2, C4), deren Kapazitätswerte mittels einer Steuerspannung (UE) einstellbar sind, und
einen mit dem Oszillatorkern gekoppelten Entdämpfungsverstärker mit einem ersten Transistor (T1) und einem zweiten Transistor (T2), welche miteinander in einer nichtgalvanischen Kopplung (TR1, TR2) kreuzgekoppelt sind,
wobei je ein Lastanschluß je eines Transistors (T1, T2) unmittelbar mit einem Bezugspotentialanschluß (GND) verbunden ist,
**dadurch gekennzeichnet, daß**
eine Regelungsschaltung eingerichtet zur Regelung einer Vorspannung der Transistoren (T1, T2) und zur Regelung eines Betriebsstroms des Oszillatorschaltkreises vorgesehen ist, mit einem zusätzlichen Strompfad, der einerseits mit dem Oszillatorkern gekoppelt sowie an eine Referenzstromquelle (IQ) angeschlossen ist, welche mit einer Versorgungsspannungsquelle (VQ) verbunden ist und der andererseits mit dem Bezugspotentialanschluß (GND) gekoppelt ist.

2. Oszillatorschaltkreis nach Anspruch 1,
**dadurch gekennzeichnet, daß**
zur nichtgalvanischen Kopplung von erstem und zweitem Transistor (T1, T2) ein erster Transformator (TR1) vorgesehen ist, der einen Lastanschluß des ersten Transistors (T1) mit einem Steueranschluß des zweiten Transistors (T2) induktiv koppelt, und ein zweiter Transformator (TR2) vorgesehen ist, der einen Lastanschluß des zweiten Transistors (T2) mit einem Steueranschluß des ersten Transistors (T1) induktiv koppelt.

3. Oszillatorschaltkreis nach Anspruch 2,
**dadurch gekennzeichnet, daß**
erster und zweiter Transformator jeweils ein von 1 verschiedenes Übersetzungsverhältnis aufweisen.

4. Oszillatorschaltkreis nach Anspruch 1,
**dadurch gekennzeichnet, daß**
zur nichtgalvanischen Kopplung von erstem und zweitem Transistor (T1, T2) je ein Koppelkondensator (C6, C7) zwischen Steuereingang des ersten und einem Lastanschluß des zweiten sowie Steuereingang des zweiten und einem Lastanschluß des ersten Transistors geschaltet ist.

5. Oszillatorschaltkreis nach einem der Ansprüche 1 bis 4,
**dadurch gekennzeichnet, daß**
der zusätzliche Strompfad der Regelungsschaltung für die Vorspannung der Transistoren (T1, T2) je einen Bias-Transistor (T3, T4) umfaßt, der jeweils steuerseitig an den Steuereingang des ersten beziehungsweise zweiten Transistors (T1, T2) angeschlossen und lastseitig einerseits mit dem Oszillatorkern gekoppelt sowie an die Referenzstromquelle (IQ) angeschlossen ist und andererseits mit dem Bezugspotentialanschluß (GND) verbunden ist.

6. Oszillatorschaltkreis nach einem der Ansprüche 1 bis 4,
**dadurch gekennzeichnet, daß**
der zusätzliche Strompfad der Regelungsschaltung für die Vorspannung der Transistoren (T1, T2) einen als Diode geschalteten Bias-Transistor (T5) umfaßt, der einerseits mit einer Referenzstromquelle (IQ) verbunden und mit dem Oszillatorkern gekoppelt ist und andererseits mit dem Bezugspotentialanschluß (GND) verbunden ist.

7. Oszillatorschaltkreis nach einem der Ansprüche 1 bis 6,
**dadurch gekennzeichnet, daß**
Ausgangstransistoren (T6, T7) vorgesehen sind, deren Steuereingänge mit denen des ersten bzw. zweiten Transistors (T1, T2) verbunden sind und an deren Lastanschlüssen (A1, A2) ein als Differenzsignal vorliegendes Ausgangssignal der Oszillatorschaltung ableitbar ist.

8. Oszillatorschaltkreis nach einem der Ansprüche 1 bis 7,
**dadurch gekennzeichnet, daß**
erste und zweite Kapazität je einen Kondensator (C1, C2) mit einer daran angeschlossenen Kapazitätsdiode (C3, C4) umfassen.

9. Oszillatorschaltkreis nach Anspruch 8,
**dadurch gekennzeichnet, daß**
die Kapazitätsdioden (C3, C4) anodenseitig miteinander verbunden sind.

10. Oszillatorschaltkreis nach einem der Ansprüche 1 bis 9,
**dadurch gekennzeichnet, daß**
die Transistoren (T1, T2) CMOS-Transistoren sind.

## Claims

1. Oscillator circuit, having
an oscillator core having at least one inductance (TR1) and having, connected thereto, a first capacitance (C1, C3) and a second capacitance (C2, C4), whose capacitance values are adjustable by means of a control voltage (UE), and
a deattenuation amplifier coupled to the oscillator core and having a first transistor (T1) and a second transistor (T2), which are crosscoupled to one another in a non-galvanic coupling (TR1, TR2),
a respective load terminal of a respective transistor (T1, T2) being directly connected to a reference potential terminal (GND),
**characterized in that**
a regulating circuit is set up to regulate a bias voltage of the transistors (T1, T2) and is provided to regulate an operating current of the oscillator circuit, having an additional current path which, on the one hand, is coupled to the oscillator core and is also connected to a reference current source (IQ) connected to a supply voltage source (VQ), and, on the other hand, is coupled to the reference potential terminal (GND).

2. Oscillator circuit according to Claim 1,
**characterized in that**
for the non-galvanic coupling of the first and second transistors (T1, T2), a first transformer (TR1) is provided, which inductively couples a load terminal of the first transistor (T1) to a control terminal of the second transistor (T2), and a second transformer (TR2) is provided, which inductively couples a load terminal of the second transistor (T2) to a control terminal of the first transistor (T1).

3. Oscillator circuit according to Claim 2,
**characterized in that**
the first and second transformers each have a turns ratio other than 1.

4. Oscillator circuit according to Claim 1,
**characterized in that**
for the non-galvanic coupling of the first and second transistors (T1, T2), a respective coupling capacitor (C6, C7) is connected between the control input of the first transistor and a load terminal of the second transistor and between the control input of the second transistor and a load terminal of the first transistor.

5. Oscillator circuit according to one of Claims 1 to 4,
**characterized in that**
the additional current path of the regulating circuit for the bias voltage of the transistors (T1, T2) comprises a respective bias transistor (T2, T4) which, on the control side, is in each case connected to the control input of the first and of the second transistor (T1, T2), respectively, and, on the load side, is on the one hand coupled to the oscillator core and connected to the reference current source (IQ) and on the other hand is connected to the reference potential terminal (GND).

6. Oscillator circuit according to one of Claims 1 to 4,
**characterized in that**
the additional current path of the regulating circuit for the bias voltage of the transistors (T1, T2) comprises a bias transistor (T5) connected as a diode, which bias transistor is on the one hand connected to a reference current source (IQ) and coupled to the oscillator core and on the other hand is connected to the reference potential terminal (GND).

7. Oscillator circuit according to one of Claims 1 to 6,
**characterized in that**
output transistors (T6, T7) are provided, whose control inputs are connected to those of the first and of the second transistor (T1, T2), respectively, and at whose load terminals (A1, A2) an output signal of the oscillator circuit can be drawn off, said output signal being present as a differential signal.

8. Oscillator circuit according to one of Claims 1 to 7,
**characterized in that**
the first and second capacitances respectively comprise a capacitor (C1, C2) with a variable-capacitance diode (C3, C4) connected thereto.

9. Oscillator circuit according to Claim 8,
**characterized in that**
the variable-capacitance diodes (C3, C4) are connected to one another by their anodes.

10. Oscillator circuit according to one of Claims 1 to 9,
**characterized in that**
the transistors (T1, T2) are CMOS transistors.

## Revendications

1. Circuit d'oscillateur comportant
un noyau d'oscillateur ayant au moins une inductance (TR1) et ayant une première capacité (C1, C3) qui y est raccordée et une deuxième capacité (C2, C4) dont les valeurs de capacité peuvent être réglées au moyen d'une tension (UE) de commande et un amplificateur de compensation de l'amortissement couplé au noyau d'oscillateur et ayant un premier transistor (T1) et un deuxième transistor (T2) qui sont couplés en croix l'un à l'autre suivant un couplage (TR1, TR2) non galvanique ;
respectivement, une borne de charge de, respectivement, un transistor (T1) étant reliée directement à une borne (GND) de potentiel de référence ;
**caractérisé en ce que**
il est prévu un montage de régulation destiné à réguler une tension de polarisation des transistors (T1, T2) et à réguler un courant de fonctionnement du circuit d'oscillateur et ayant un trajet de courant supplémentaire qui est couplé d'une part au noyau d'oscillateur ainsi que raccordé à une source (IQ) de courant de référence, laquelle est reliée à une source (VQ) de tension d'alimentation et qui, d'autre part, est couplée à la borne (GND) de potentiel de référence.

2. Circuit d'oscillateur suivant la revendication 1,
**caractérisé en ce que**
il est prévu pour le couplage non galvanique du premier et deuxième transistors (T1, T2) un premier transformateur (TR1) qui couple inductivement une borne de charge du premier transistor (T1) à une borne de commande du deuxième transistor (T2) et il est prévu un deuxième transformateur (TR2) qui couple inductivement une borne de charge du deuxième transistor (T2) à une borne de commande du premier transistor(T1).

3. Circuit d'oscillateur suivant la revendication 2,
**caractérisé en ce que**
le premier et le deuxième transformateurs ont, respectivement, un rapport de transformation différent de 1.

4. Circuit d'oscillateur suivant la revendication 1,
**caractérisé en ce que**
pour le couplage non galvanique du premier et du deuxième transistors (T1, T2), il est monté, respectivement, un condensateur (C6, C7) de couplage entre une entrée de commande du premier transistor et une borne de charge du deuxième transistor ainsi qu'entre une entrée de commande du deuxième transistor et une borne de charge du premier transistor.

5. Circuit d'oscillateur suivant l'une des revendications 1 à 4,
**caractérisé en ce que**
le trajet de courant supplémentaire du montage de régulation pour la tension de polarisation des transistors (T1, T2) comporte, respectivement, un transistor (T3, T4) de polarisation qui est raccordé, respectivement, du côté de commande à l'entrée de commande du premier et, respectivement, du deuxième transistors (T1, T2) et qui du côté de la charge d'une part est couplé au noyau d'oscillateur ainsi que raccordé à la source (IQ) de courant de référence et d'autre part est relié à la borne (GND) de potentiel de référence.

6. Circuit d'oscillateur suivant l'une des revendications 1 à 4,
**caractérisé en ce que**
le trajet de courant supplémentaire du montage de régulation pour la tension de polarisation des transistors (T1, T2) comprend un transistor (T5) de polarisation monté en diode qui, d'une part, est relié à une source (IQ) de courant de référence et couplé au noyau d'oscillateur et, d'autre part, est relié à la borne (GND) de potentiel de référence.

7. Circuit d'oscillateur suivant l'une des revendications 1 à 6,
**caractérisé en ce que**
il est prévu des transistors (T6, T7) de sortie dont les entrées de commande sont reliées à celles du premier et du deuxième transistors (T1, T2) et sur les bornes (A1, A2) de charge desquelles peut être dérivé un signal de sortie du circuit d'oscillateur se présentant sous la forme d'un signal de différence.

8. Circuit d'oscillateur suivant l'une des revendications 1 à 7,
**caractérisé en ce que**
la première et la deuxième capacités comprennent, respectivement, un condensateur (C1, C2) ayant une diode (C3, C4) de capacité qui y est raccordée.

9. Circuit d'oscillateur suivant la revendication 8,
**caractérisé en ce que**
les diodes (C3, C4) de capacité sont reliées entre elles du côté de l'anode.

10. Circuit d'oscillateur suivant l'une des revendications 1 à 9,
**caractérisé en ce que**
les transistors (T1, T2) sont des transistors CMOS.
